# EUROPÄISCHE PATENTANMELDUNG

(11) **EP 4 290 263 A1**
(43) Veröffentlichungstag der Anmeldung: **13.12.2023**
(21) Anmeldenummer: 22177992.9
(22) Anmeldetag: 09.06.2022
(51) Int. Cl.: G01R 33/56, G06N 3/08, G06T 5/50, G01R 33/565

(54) **VERFAHREN UND VORRICHTUNG ZUR BEREITSTELLUNG VON MRT-AUFNAHMEN IN BEZUG AUF ZUMINDEST EIN KÖRPERTEIL EINES PATIENTEN MIT REDUZIERTER KONTRASTMITTELGABE**

(71) Anmelder: Rheinische Friedrich-Wilhelms-Universität Bonn, 53113 Bonn (DE)
(72) Erfinder: Radbruch, Alexander, 53115 Bonn (DE); Effland, Alexander, 53227 Bonn (DE)
(74) Vertreter: RCD-Patent Giesen, Schmelcher & Griebel Patentwanwälte PartG mbB

(57) **Zusammenfassung**

Die Erfindung betrifft ein Verfahren und eine Vorrichtung (1) zur Bereitstellung von MRT-Aufnahmen in Bezug auf zumindest ein Körperteil eines Patienten mit reduzierterer Kontrastmittelgabe. Die Vorrichtung (1) weist
• Eingabemittel zum Erhalt von MRT-Aufnahmen in Bezug auf zumindest ein Körperteil eines Patienten ohne Kontrastmittelgabe,
• Eingabemittel zum Erhalt von MRT-Aufnahmen in Bezug auf zumindest das Körperteil des Patienten mit Kontrastmittelgabe, wobei die für das Körperteil zugelassene Kontrastmittelgabe um mindestens 50 % reduziert ist gegenüber einer herkömmlichen MRT-Aufnahme,
• Mittel zur Bildregistrierung der MRT-Aufnahmen ohne Kontrastmittelgabe und der MRT-Aufnahmen mit Kontrastmittelgabe, wobei die Mittel zur Bildregistrierung im dreidimensionalen Raum operieren,
• Mittel zur Erstellung von zumindest einem Subtraktionsbild aus dem Vergleich von bildregistrierten MRT-Aufnahmen ohne Kontrastmittelgabe und bildregistrierten MRT-Aufnahmen mit Kontrastmittelgabe,
• Mittel zur Kontrastverstärkung basierend auf dem Subtraktionsbild, wobei die Mittel zur Kontrastverstärkung auf Basis eines trainierten neuronalen Netzwerkes zum einen mittels einer nichtlinearen Transformation eine Verstärkung als auch eine Artefaktreduktion bereitstellen,
auf.

Weiterhin betrifft die Erfindung ein Computerprogrammprodukt und die Verwendung von erfindungsgemäßen Verfahren und Vorrichtungen.

## Beschreibung

Zur Diagnosestellung wird in vielen Bereichen der Human- als auch der Veterinärmedizin auf Magnetresonanztomographen (abgekürzt MRT) zurückgegriffen.

Die Magnetresonanztomographie ist ein bildgebendes Verfahren, das zur Darstellung von Struktur und Funktion der Gewebe und Organe im Körper eingesetzt wird. Die Magnetresonanztomographie basiert physikalisch auf den Prinzipien der Kernspinresonanz. In aller Regel wird dabei ein starkes Magnetfeld mit einem magnetischen Wechselfeld überlagert, wobei das Wechselfeld so ausgestaltet ist, dass es zu einer resonanten Anregung von (bestimmten) Atomkernen führt. Diese resonante Anregung kann in einer Empfangsspule detektiert werden.

Die Helligkeit unterschiedlicher Gewebetypen in einem Bild wird durch deren Relaxationszeiten und den Gehalt von angeregten Atomkernen beeinflusst. Welcher dieser Parameter den Bildkontrast dominiert, wird durch die Wahl der Pulssequenz beeinflusst.

Üblicherweise werden dabei verschiedene Sequenzen von Aufnahmen aufgenommen. Ebenso ist es üblich, dass es bei bestimmten Untersuchungen von Vorteil ist, Kontrastmittel (intravenös) zu verabreichen. Kontrastmittel führen bei kontrastmittelverstärkten MRT-Aufnahmen dazu, dass bei der entsprechenden Aufnahme die Signalintensität gewisser Regionen verstärkt wird. Die signalverstärkten Regionen weisen dabei eine deutlich höhere Signalintensität als die entsprechenden Regionen in den nativen MRT-Aufnahmen auf.

Diese Kontrastmittel, z.B. basierend auf Gadolinium, sind jedoch nicht unbedenklich, sondern es besteht die Möglichkeit, dass sich Kontrastmittel im Körper anreichern und zu Vergiftungssymptomen führen können. Ebenso stellen ausgeschiedene Kontrastmittel ein Problem für Gewässer dar.

Unabhängig von einer Gefährdung eines Patienten oder der Umwelt sind Kontrastmittel aber auch teuer.

Bei der Befundung von MRT-Aufnahmen sind Kontrastmittel heutzutage ein essentieller Bestandteil. Zugleich stehen Kontrastmittel (z.B. Gadolinium) im Verdacht gesundheitsschädlich zu sein und verursachen hohe Kosten im Gesundheitswesen.

Zwar gibt es neuere Entwicklungen hin zu anderen Kontrastmitteln, die weniger gesundheitsschädlich sein sollen, jedoch sind diese immer noch sehr teuer.

Bisherige Ansätze, die versuchten die Kontrastmittelgabe zu reduzieren und die so erhaltenen Daten mittels künstlicher Intelligenz aufzuarbeiten, waren nur teilweise erfolgreich.

Zum einen setzen diese Ansätze das Training mit mehreren unterschiedlich dosierten Kontrastmittelgaben voraus, sodass das Training sehr aufwändig ist. Ebenso zeigt sich, dass die Verarbeitungsgeschwindigkeit solch komplexer Netzwerke gering ist, sodass der Aufwand für die Berechnung der Daten hoch und damit zeitaufwändig ist.

Um dies zu kompensieren wird daher auf Schichtbildebene die Verarbeitung durchgeführt. Dies führt aber dazu, dass die entsprechenden Netzwerke nur in der Schichtebene qualitativ gute Ergebnisse liefern, für eine Gesamtschau jedoch nachteilig sind.

Werden zudem die Daten aller Datenpunkte verarbeitet, kommt es häufig zu Artefakten, sodass auch hier Nachteile entstehen können.

### Aufgabe

Ausgehend hiervon ist es ein Ziel der Erfindung eine Verbesserung bereitzustellen, die es erlaubt Kontrastmittel jeglicher Art zu reduzieren, ohne dass es zu einem wahrnehmbaren Verlust an Information kommt.

### Kurzdarstellung der Erfindung

Die Aufgabe wird gelöst durch eine Vorrichtung zur Bereitstellung von MRT-Aufnahmen in Bezug auf zumindest ein Körperteil eines Patienten mit reduzierter Kontrastmittelgabe gemäß Anspruch 1.

Die Aufgabe wird auch gelöst durch ein Verfahren zur Bereitstellung von MRT-Aufnahmen in Bezug auf zumindest ein Körperteil eines Patienten mit reduzierter Kontrastmittelgabe gemäß Anspruch 6.

Die Aufgabe wird auch gelöst durch ein Computerprogrammprodukt und die Verwendung von erfindungsgemäßen Verfahren und Vorrichtungen.

Weitere vorteilhafte Ausgestaltungen sind Gegenstand der jeweils abhängigen Ansprüche, der Figuren und der Beschreibung.

### Kurzdarstellung der Figuren

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Fig. 1-4: schematische Darstellung von Verfahrensaspekten gemäß Ausführungsformen der Erfindung,
- Fig. 5-14: beispielhafte MRT-Aufnahmen zur Verwendung in Ausführungsformen der Erfindung bzw. erhalten in Verfahren gemäß Ausführungsformen der Erfindung und
- Fig. 15: eine schematische Darstellung von Vorrichtungsaspekten gemäß Ausführungsformen der Erfindung.

### Ausführliche Darstellung der Erfindung

Nachfolgend wird die Erfindung eingehender unter Bezugnahme auf die Figuren dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Weiterhin wird nachfolgend der Einfachheit halber in aller Regel immer nur auf eine Entität Bezug genommen. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/-1 % bis zu +/- 10 %.

Soweit in dieser Anmeldung Normen, Spezifikationen oder dergleichen benannt werden, werden zumindest immer die am Anmeldetag anwendbaren Normen, Spezifikationen oder dergleichen in Bezug genommen. D.h. wird eine Norm / Spezifikation etc. aktualisiert oder durch einen Nachfolger ersetzt, so ist die Erfindung auch hierauf anwendbar.

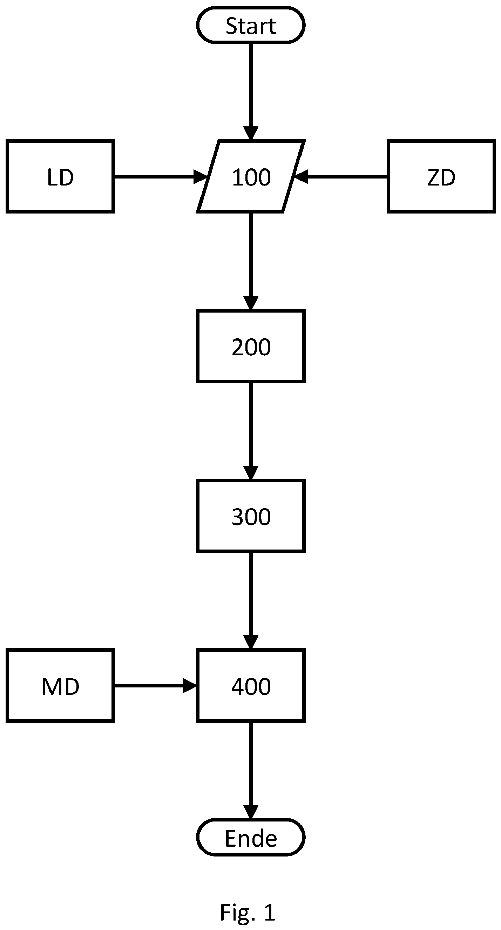

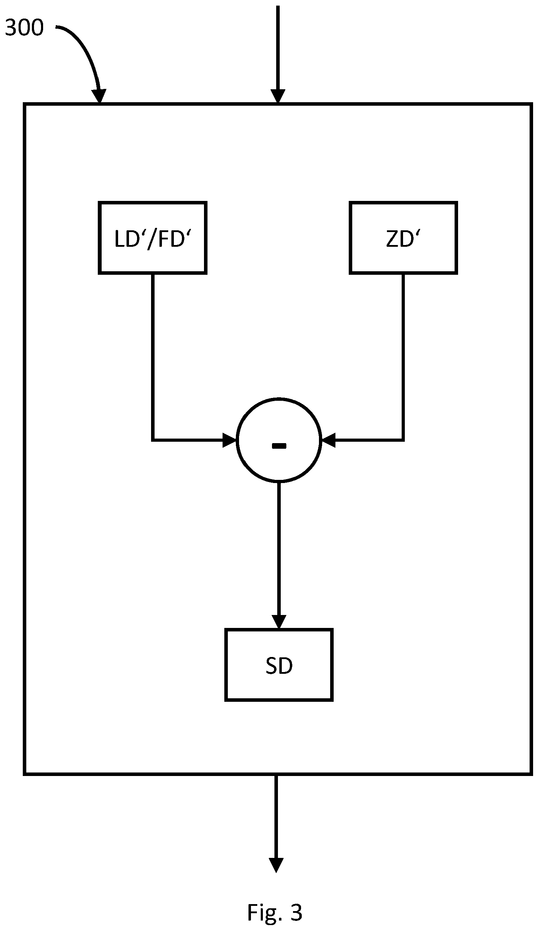

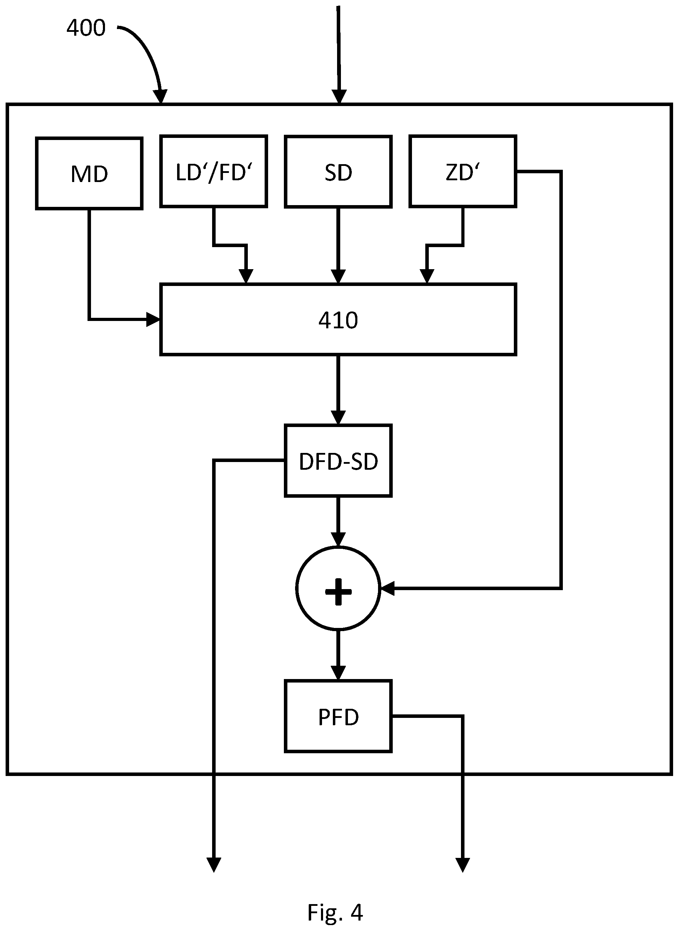

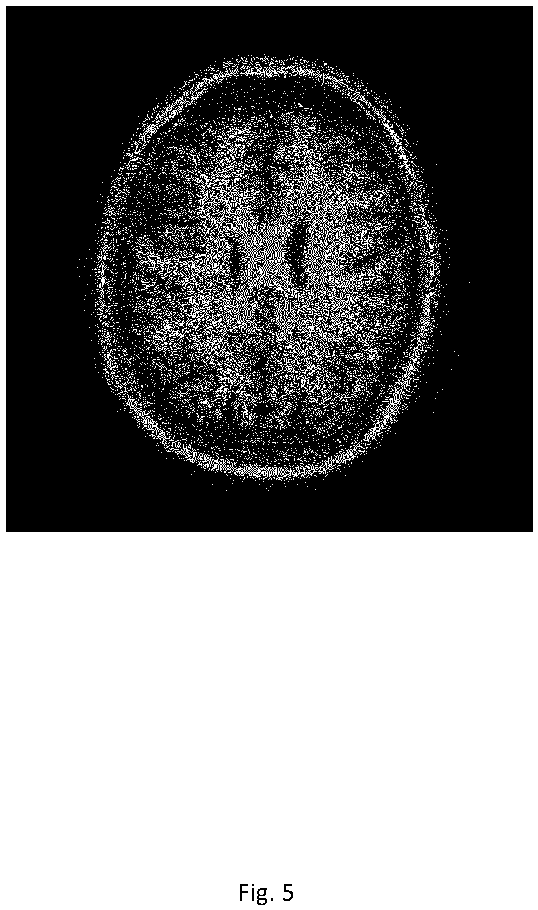

In den Figuren 1 bis 4 und 15 sind Aspekte in Bezug auf verschiedene Ausführungsformen dargestellt. In den Figuren 5 bis 14 hingegen sind beispielhafte MRT-Aufnahmen dargestellt, die zur Erläuterung nachstehend herangezogen werden.

Nachfolgend werden in der Beschreibung/Figuren Referenzzeichen mit Hochkomma als auch ohne Hochkomma verwendet. Die Anbringung eines Hochkommas signalisiert, dass eine (optionale) Vorverarbeitung, z.B. eine Reskalierung/ Normalisierung/ Registrierung etc. stattgefunden hat. Soweit eine solche Vorverarbeitung nicht notwendig ist, z.B. weil bereits eine gleiche Größe der MRT-Aufnahme vorhanden ist, ist nachfolgend angenommen, dass Referenzzeichen mit und ohne Hochkomma synonym zu verwenden sind.

Eine erfindungsgemäße Vorrichtung 1 zur Bereitstellung von MRT-Aufnahmen in Bezug auf zumindest ein Körperteil eines Patienten mit reduzierter Kontrastmittelgabe weist zumindest Eingabemittel zum Erhalt von MRT-Aufnahmen in Bezug auf zumindest ein Körperteil eines Patienten ohne Kontrastmittelgabe, und Eingabemittel zum Erhalt von MRT-Aufnahmen in Bezug auf zumindest das Körperteil des Patienten mit Kontrastmittelgabe auf, wobei die für das Körperteil zugelassene Kontrastmittelgabe um mindestens 50 % reduziert ist gegenüber einer herkömmlichen MRT-Aufnahme.

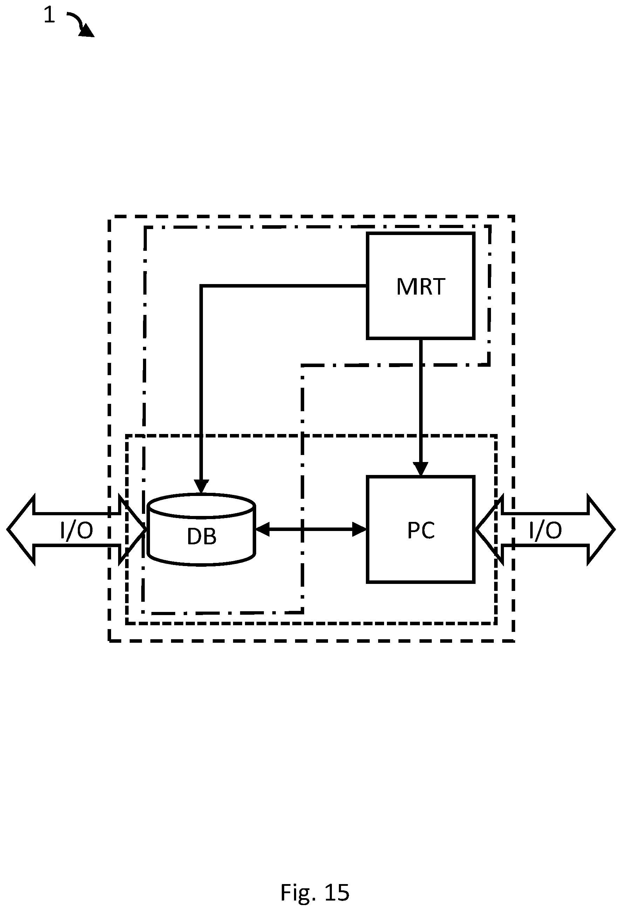

Ohne Beschränkung der Allgemeinheit kann die Vorrichtung 1 beispielsweise in einem programmtechnisch eingerichteten PC verkörpert sein. Ebenso kann - wie in Figur 15 angedeutet - die Vorrichtung 1 auch in ein MRT-Gerät integriert sein. Auch ist es möglich, dass die Vorrichtung 1 neben einem PC auch einen Datenspeicher DB enthält. Beispielsweise kann mittels einer geeigneten optionalen Schnittstelle I/O (z.B. eine Schnittstelle zum Internet) auch die Verarbeitung gemäß erfindungsgemäßen Verfahren als Dienstleistung angeboten werden. Mittels einer solchen Schnittstelle I/O können auch Daten von oder zu einem Datenspeicher DB und/oder zum Abruf durch die Vorrichtung 1 bzw. den PC als auch zum Abruf und/oder Bereitstellung von/an eine externe Quelle, z.B. einem entfernten MRT-Gerät oder einem externen Darstellungsgerät - z.B. zur Diagnosestellung / Befundung -, bereitgestellt werden.

D.h. die Schnittstellen I/O können ebenso wie eine direkte Anbindung (über eine bestimmte Schnittstelle und/oder ein lokales Netzwerk) als Eingabemittel an eine erfindungsgemäße Vorrichtung 1 verstanden werden.

Die erfindungsgemäße Vorrichtung 1 weist weiterhin Mittel zur Bildregistrierung der MRT-Aufnahmen ohne Kontrastmittelgabe und der MRT-Aufnahmen mit Kontrastmittelgabe auf, wobei die Mittel zur Bildregistrierung im dreidimensionalen Raum operieren.

Diese Mittel können ebenfalls programmtechnisch in einer Vorrichtung 1 eingerichtet sein.

Die erfindungsgemäße Vorrichtung 1 weist weiterhin Mittel zur Erstellung von zumindest einem Subtraktionsbild aus dem Vergleich von bildregistrierten MRT-Aufnahmen ohne Kontrastmittelgabe und bildregistrierten MRT-Aufnahmen mit Kontrastmittelgabe auf.

Diese Mittel können ebenfalls programmtechnisch in einer Vorrichtung 1 eingerichtet sein.

Die erfindungsgemäße Vorrichtung 1 weist weiterhin Mittel zur Kontrastverstärkung basierend auf dem Subtraktionsbild auf, wobei die Mittel zur Kontrastverstärkung auf Basis eines trainierten neuronalen Netzwerkes zum einen mittels einer nichtlinearen Transformation eine Verstärkung als auch eine Artefaktreduktion bereitstellen.

Diese Mittel können ebenfalls programmtechnisch in einer Vorrichtung 1 eingerichtet sein.

In entsprechender Weise weist ein erfindungsgemäßes Verfahren zur Bereitstellung von MRT-Aufnahmen in Bezug auf zumindest ein Körperteil eines Patienten mit reduzierter Kontrastmittelgabe einen Schritt des Erhaltens 100 von MRT-Aufnahmen in Bezug auf zumindest ein Körperteil eines Patienten ohne Kontrastmittelgabe ZD und einen Schritt des Erhaltens 100 von MRT-Aufnahmen in Bezug auf zumindest das Körperteil des Patienten mit Kontrastmittelgabe LD auf, wobei die für das Körperteil zugelassene Kontrastmittelgabe um mindestens 50 % reduziert ist gegenüber einer herkömmlichen MRT-Aufnahme.

Das erfindungsgemäße Verfahren weist weiterhin einen Schritt des Durchführens einer Bildregistrierung 200 der MRT-Aufnahmen ohne Kontrastmittelgabe und der MRT-Aufnahmen mit Kontrastmittelgabe auf, wobei die Mittel zur Bildregistrierung im dreidimensionalen Raum operieren.

Weiterhin weist das erfindungsgemäße Verfahren einen Schritt des Erstellens 300 von zumindest einem Subtraktionsbild SD aus dem Vergleich von bildregistrierten MRT-Aufnahmen ohne Kontrastmittelgabe und bildregistrierten MRT-Aufnahmen mit Kontrastmittelgabe auf.

Darüber hinaus weist das erfindungsgemäße Verfahren einen Schritt des Bereitstellens einer Kontrastverstärkung 400 basierend auf dem Subtraktionsbild SD auf, wobei auf Basis eines trainierten neuronalen Netzwerkes zum einen mittels einer nichtlinearen Transformation eine Verstärkung als auch eine Artefaktreduktion bereitgestellt wird.

In einer Ausführungsform der Erfindung stellen die Mittel zur Bildregistrierung eine Starrkörperregistrierung in drei Dimensionen bereit. In entsprechender Weise kann in einem erfindungsgemäßen Verfahren im Schritt der Bildregistrierung 200 auch eine Starrkörperregistrierung 210 in drei Dimensionen bereitgestellt werden.

Bevorzugt ist die Starrkörperregistrierung 210 in drei Dimensionen eine Multiskalen-Starrkörperregistrierung. Weiterhin optional kann zur Optimierung ein nicht-lineares Optimierungsverfahren mit Schrittweitensteuerung verwendet werden.

Die Bildregistrierung 200 wird bevorzugt auf alle Aufnahmen angewendet, die auch für den Rest der Verarbeitung bevorzugt beibehalten wird.

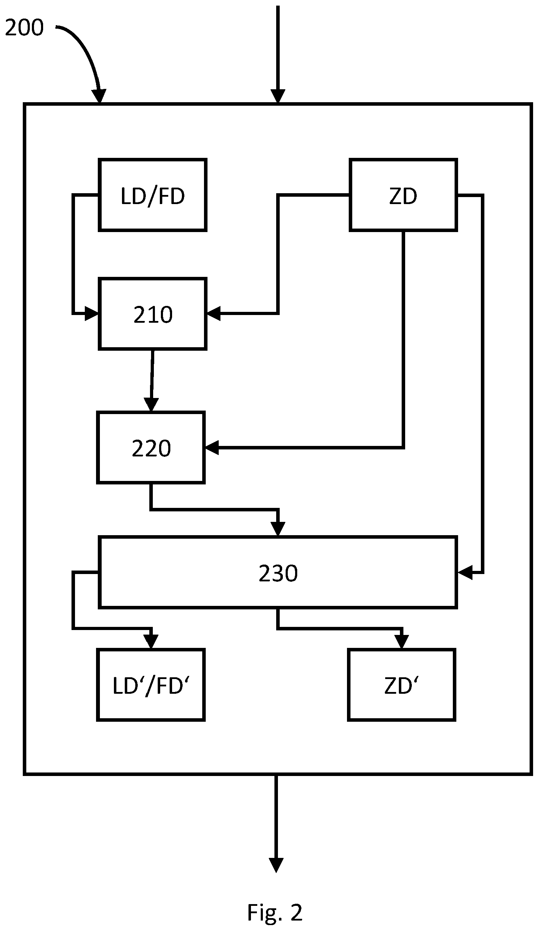

Wie aus Figur 2 ersichtlich ist, kann der Schritt der Bildregistrierung 200 auch noch weitere Schritte aufweisen. So kann z.B. ein Schritt der radiometrischen Registrierung 220 und/oder auch ein Schritt der Normalisierung 230 vorgesehen sein.

Mittels der Normalisierung in Schritt 230 können die Aufnahmen so normiert werden, dass die Signalintensitäten der nicht durch das Kontrastmittel hervorgehobenen Regionen approximativ übereinstimmen. Dies kann auch als eine Anpassung der Grauskalierung verstanden werden.

Insbesondere kann die Normierung der Intensitäten eine Studentsche t-Normierung oder eine Nyul Normierung sein, ohne jedoch die Verwendung anderer Normierungen auszuschließen.

Insbesondere kann bei der radiometrischen Registrierung 220 vorgesehen sein, dass Bereiche mit Kontrastmittelverstärkung (z.B. aus einem Vergleich von Aufnahmen mit Kontrastmittel FD, LD, FD', LD' und Aufnahmen ohne Kontrastmittel ZD desselben Bereiches) oder aber des Subtraktionsbildes SD / SD' hiervon ausgenommen (maskiert) bleiben. Dies kann aber auch mittels eines hohen Quantils, z.B. einem 95% Quantil der Intensität, von MRT-Aufnahmen mit Kontrastmittel FD, SD abgeschätzt werden. D.h. das Funktional kann eine reskalierte Student-t-Funktion sein.

In einer Ausführungsform der Erfindung weist die Vorrichtung 1 weiterhin Mittel zur Interpolation auf, sodass MRT-Aufnahmen unterschiedlicher Auflösung auf eine gemeinsame Auflösung vor einer weiteren Verarbeitung interpoliert werden können. In entsprechender Weise kann auch das Verfahren bevorzugt in Schritt 200 einen Unterschritt der Interpolation aufweisen. Dieser Schritt der Interpolation kann im Prinzip innerhalb der Unterschritte beliebig angeordnet sein. Somit kann für alle nachfolgenden Schritte von einer gleichen Aufnahmegröße ausgegangen werden, sodass die Verarbeitung vereinheitlicht parallel oder sequentiell ablaufen kann, soweit unterschiedliche MRT-Aufnahmen die gleichen Schritte durchlaufen. Auch erleichtert dies die weitere Verarbeitung dahingehend, dass z.B. Addition und Subtraktion auf Pixelebene durchgeführt werden können, während dies bei ungleichgroßen Aufnahmen nicht ohne weiteres möglich wäre.

Insbesondere kann bei der Interpolation vorgesehen sein, dass MRT-Aufnahmen unterschiedlicher Auflösung auf eine gemeinsame isotrope Auflösung überführt werden können.

In Schritt 400 kann mittels eines geeignet trainierten neuronalen Netzwerkes in einem Schritt 410 aus vorhandenen (und gegebenenfalls vorverarbeiteten MRT-Aufnahmen) ohne Kontrastmittelgabe ZD bzw. mit Kontrastmittelgabe LD, LD' dann ein vorhergesagtes kontrastverstärktes Differenzbild DFD-SD erstellt werden. Dieses vorhergesagte kontrastverstärkte Differenzbild DFD-SD kann dann zu den MRT-Aufnahmen ohne Kontrastmittel ZD, ZD' hinzugefügt werden, sodass zum einen mittels einer nichtlinearen Transformation eine Verstärkung als auch eine Artefaktreduktion bereitgestellt wird.

In Ausführungsformen der Erfindung kann zudem vorgesehen sein, dass für die Bereitstellung einer Kontrastverstärkung 400 auch auf zumindest ein Metadatum MD zurückgegriffen wird. Dieses kann zum einen zu Beginn des Verfahrens bereitgestellt werden, oder aber zu jedem anderen Zeitpunkt vor der Verwendung eingegeben, ermittelt oder übertragen werden.

Insbesondere kann das zumindest eine Metadatum (MD) ausgewählt sein aus einer Gruppe aufweisend Geräteidentifikation, bei der Messung verwendete Feldstärke(n), bei der Messung verwendetes Kontrastmittel, bei der Messung verwendete Kontrastmittelgabe (absolut und relativ), Gewicht des Patienten, Alter des Patienten, Größe des Patienten, Geschlecht des Patienten, Status des Patienten (z. B. prä-/ post-operativ).

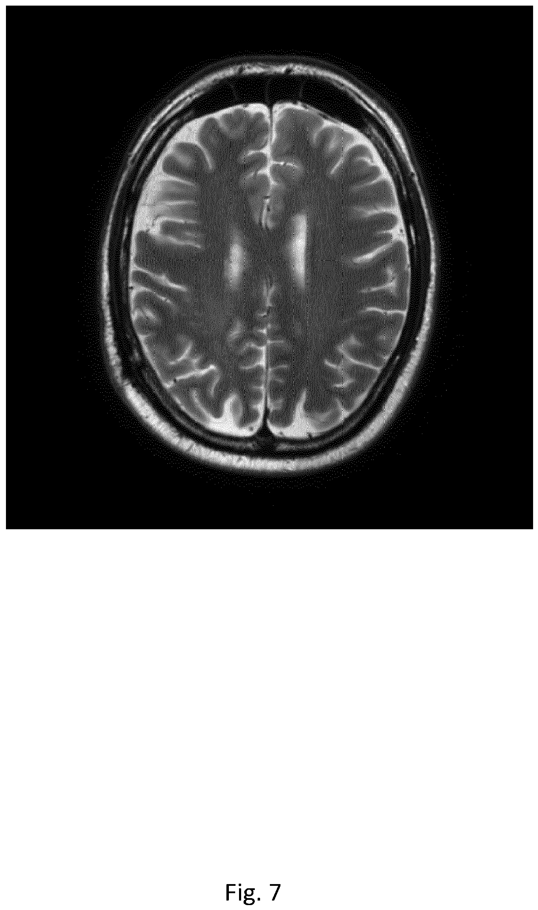

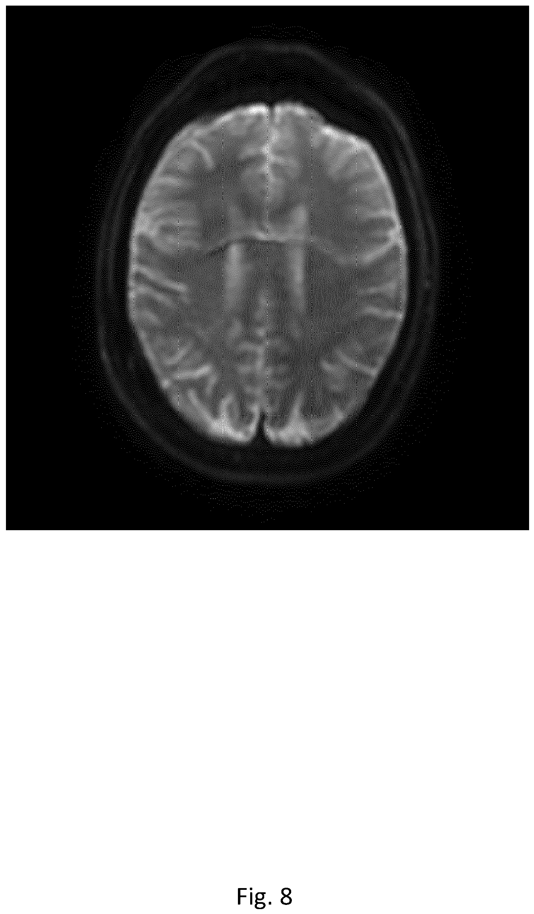

D.h. in einem erfindungsgemäßen/r Verfahren / Vorrichtung wird zunächst bevorzugt eine dreidimensionale, isotrope T1-gewichtete MRT-Aufnahme (Fig. 5) sowie eine T2- gewichtete MRT-Aufnahme (Fig. 7) und gegebenenfalls eine diffusionsgewichtete Aufnahme ohne Kontrastmittelgabe (Fig. 8) durch ein MRT-Gerät akquiriert oder aus einem Datenspeicher DB ausgelesen. Diese MRT-Aufnahmen werden auch als Zero-Dose-Aufnahmen ZD bezeichnet.

Da eine Kontrastmittelgabe nicht unmittelbar zu einer Perfusion führt, können aus Verlaufsdaten nach Kontrastmittelgabe weitere Informationen abgeleitet werden.

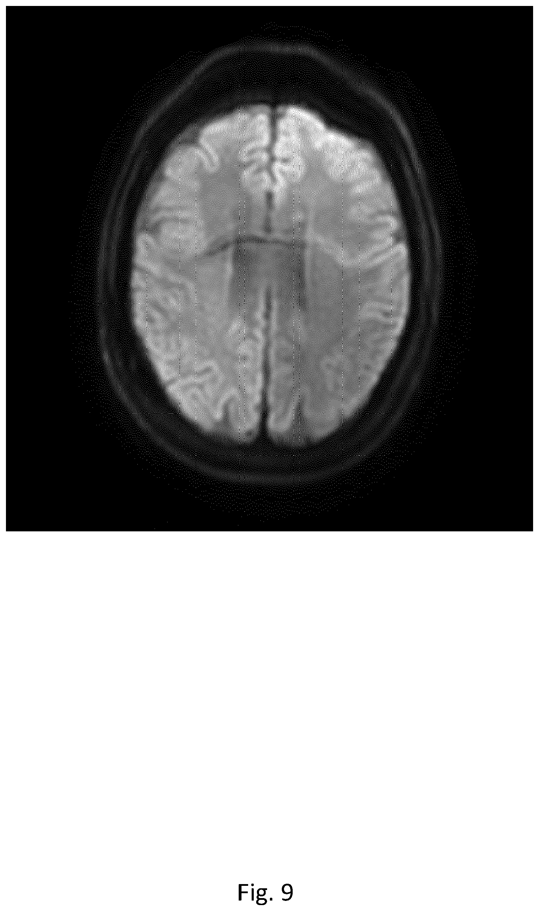

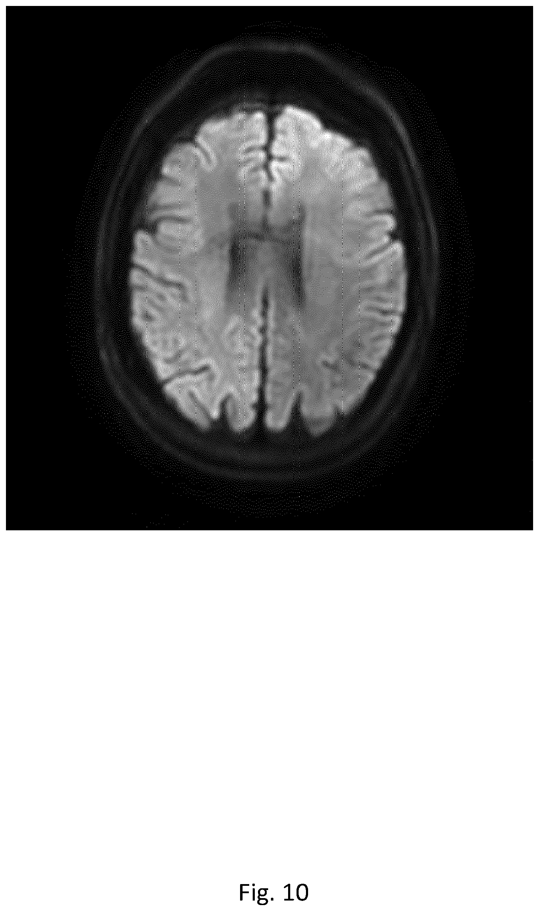

Figur 8-10 stellen z.B. diffusionsgewichtete MRT-Aufnahmen entsprechend unterschiedlicher Protokolle, z.B. b-Wert: (Figur 8), 500 (Figur 9) und 1000 (Figur 10) dar.

Da Kontrastmittel im Vergleich zur Dauer einer MRT-Aufnahme langsam ausgeschieden werden, werden MRT-Aufnahmen ohne Kontrastmittel zu Beginn erstellt.

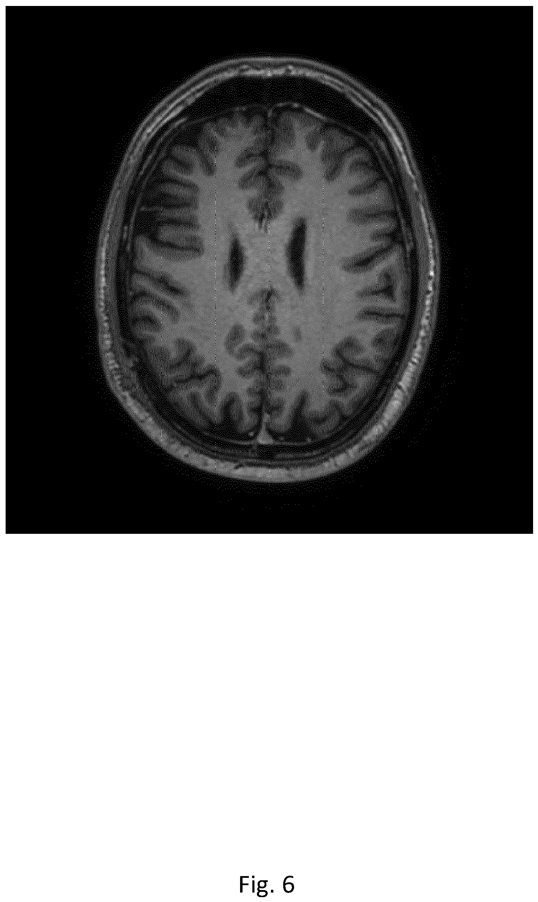

Anschließend erfolgt das Akquirieren aus einem MRT-Gerät oder durch Auslesen aus einem Datenspeicher DB einer weiteren den obigen Kriterien entsprechenden T1-gewichteten MRT-Aufnahme (Fig. 6) nach Gabe einer deutlich reduzierten Dosis des Kontrastmittels.

Dabei reicht es - insbesondere auch experimentell - aus, die Kontrastmittelgabe in den Bereich von etwa 10 % der zulässigen Kontrastmittelgabe zu reduzieren. Diese MRT-Aufnahmen werden auch als Low-Dose-Aufnahmen LD bezeichnet.

Bevorzugt werden die MRT-Aufnahmen nach dem Erhalt normiert, so dass die Signalintensitäten der nicht durch das Kontrastmittel hervorgehobenen Regionen approximativ übereinstimmen. Hierbei kann z.B. ein Funktional minimiert werden, welches die Distanz zwischen den zu normierenden Aufnahmen beschreibt. Das Funktional kann eine reskalierte Student-t-Funktion sein. Bereiche der Kontrastmitteverstärkung können dabei ausmaskiert sein. Solche Bereiche können auf Basis des 95 %-Quantil der Intensitäten der Kontrastmittelbilder errechnet werden.

Vor einer weiteren Verarbeitung können die MRT-Aufnahmen, z.B. die (isotropen) T1-gewichteten Aufnahmen ohne Kontrastmittelgabe (Fig. 5) als auch die (isotropen) T1-gewichteten Aufnahmen mit Kontrastmittelgabe (Fig. 6) einer Bildregistrierung im dreidimensionalen Raum zugeführt werden, sodass eine - bevorzugt exakt - gleichgerichtete räumliche Ausrichtung gegeben ist.

Ebenso können auch die T2- und diffusionsgewichteten Aufnahmen ohne Kontrastmittelgabe im dreidimensionalen Raum registriert werden.

Das verwendete Verfahren ist bevorzugt eine Multiskalen-Starrkörperregistrierung, wobei zur Optimierung ein konjugiertes Gradientenverfahren mit einer Line-Search-Bedingung als eine beispielhaftes nicht-lineares Optimierungsverfahren mit Schrittweitensteuerung verwendet werden kann.

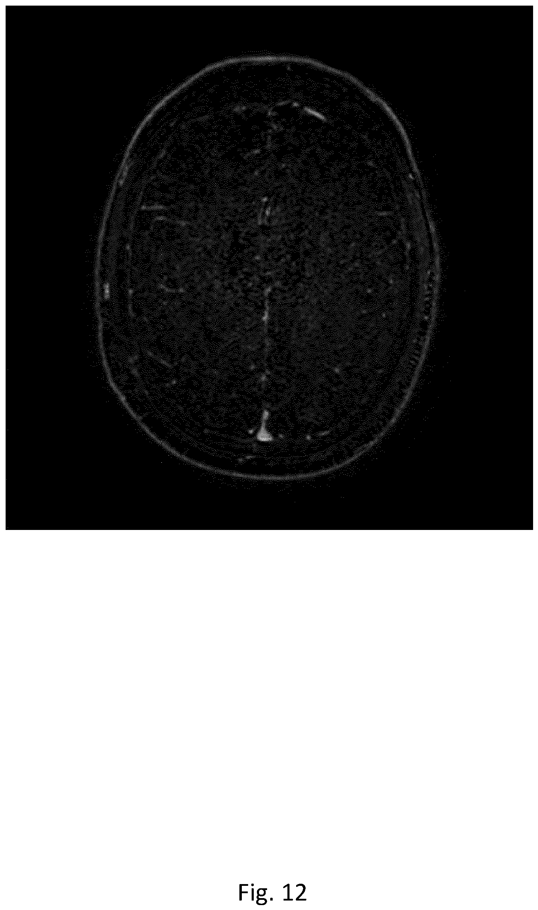

Aus den bildregistrierten (isotropen) T1-gewichteten Aufnahmen ohne Kontrastmittelgabe (Fig. 5) als auch den (isotropen) T1-gewichteten Aufnahmen mit Kontrastmittelgabe (Fig. 6) kann ein Subtraktionsbild (Fig. 12) der beiden (bildregistrierten) MRT-Aufnahmen erzeugt werden, in dem im Wesentlichen die durch das Kontrastmittel erzeugten Signale (sowie unter Umständen Artefakte) sichtbar sind.

Auf das Subtraktionsbild (Fig. 12) kann dann eine fixe nichtlineare Transformation angewendet werden, um das Kontrastsignal zu verstärken. Beispielsweise kann hier die Funktion f(x)=max(x,c) verwendet werden, bei der alle Pixelwerte unterhalb einer Schranke c auf eben diesen Wert gesetzt werden.

Mittels eines neuronalen Netzwerkes mit dreidimensionalen Konvolutionen können die Signale auf dem transformierten Subtraktionsbild verstärkt und zugleich mögliche vorhandenen Artefakte beseitigt werden. Als Input des neuronalen Netzwerkes können zumindest die T1-gewichteten Aufnahmen mit Kontrastmittelgabe LD/LD' und ohne Kontrastmittelgabe ZD/ZD', optional T2-gewichtete Aufnahmen und weiter optional Diffusionsaufnahmen sowie natürlich das errechnete (und transformierte) Subtraktionsbild SD verwendet werden. Weitere Metadaten MD oder weitere Aufnahmen können ebenfalls in das neuronale Netzwerk optional eingegeben werden. Am Ausgang des neuronalen Netzwerks wird ein entrauschtes dreidimensionales Subtraktionsbild DFS-SD (Fig. 12) bereitgestellt, in dem die durch das Kontrastmittel zu detektierenden Regionen deutlicher erkennbar sind. Dieses Subtraktionsbild DFS-SD approximiert das bisher standardmäßig diagnostisch genutzte Subtraktionsbild.

Das neuronale Netzwerk ist bevorzugt ein Feedforward-Netzwerk bestehend aus bevorzugt sieben konsekutiven Konvolutionsblöcken, wobei die ersten drei Blöcke z.B. dazu verwendet werden können die Auflösung zu reduzieren und z.B. die letzten drei Blöcke dazu verwendet werden können die Auflösung zu erhöhen, so dass nach dem finalen Block die ursprüngliche Auflösung erhalten wird. Insbesondere können zwei Blöcke der gleichen Auflösung durch residuale Verbindungen verknüpft sein. Zur Unterstützung mehrerer Auflösungen kann zusätzlich im zweiten Block ein entsprechend niedriger aufgelöstes Eingabebild hinzugefügt werden. Als optionale Eingaben können z.B. Metadaten MD verwenden werden, wie z.B. Kontrastmitteldosis (absolut und/oder relativ), Kontrastmittelart, Feldstärke(n), verwendetes Gerät, verwendete Spule(n), etc.

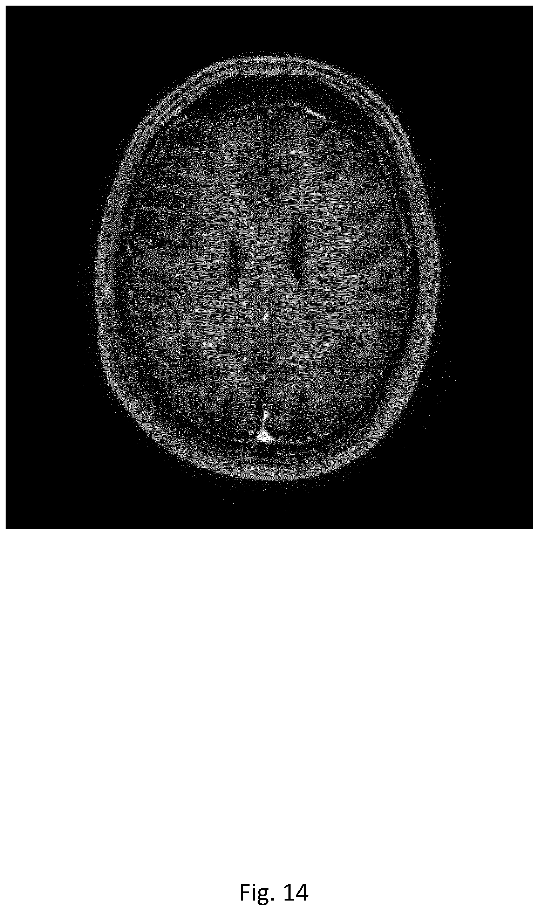

Zur besseren anatomischen Abgrenzung und morphologischen Zuordnung kann durch Addition des entrauschten Subtraktionsbilds DFD-SD zur T1-gewichteten nativen MRT-Aufnahme ZD eine T1-gewichtete MRT-Aufnahme PFD generiert werden (Fig. 14), die der Full-Dose-MRT-Aufnahme gleicht.

Wie bereits ersichtlich wird im Rahmen der Erfindung auch ein neuronales Netzwerk verwendet. Dieses muss vor Verwendung geeignet trainiert sein.

Zur Vervollständigung der erfindungsgemäßen Lehre wird nunmehr kurz auf den Trainingsprozess eingegangen werden.

Für das Training werden neben den oben beschriebenen Aufnahmen ohne und mit verminderter Kontrastmittelgabe auch - bevorzugt gleichartige dreidimensionale, isotrope - T1-gewichtete MRT-Aufnahmen mit der vollen Dosis des Kontrastmittels verwendet.

Anschließend werden die erhaltenen Daten - wie zuvor beschrieben - normiert, so dass die Signalintensitäten der nicht durch das Kontrastmittel hervorgehobenen Regionen approximativ übereinstimmen, und eine Bildregistrierung wird durchgeführt.

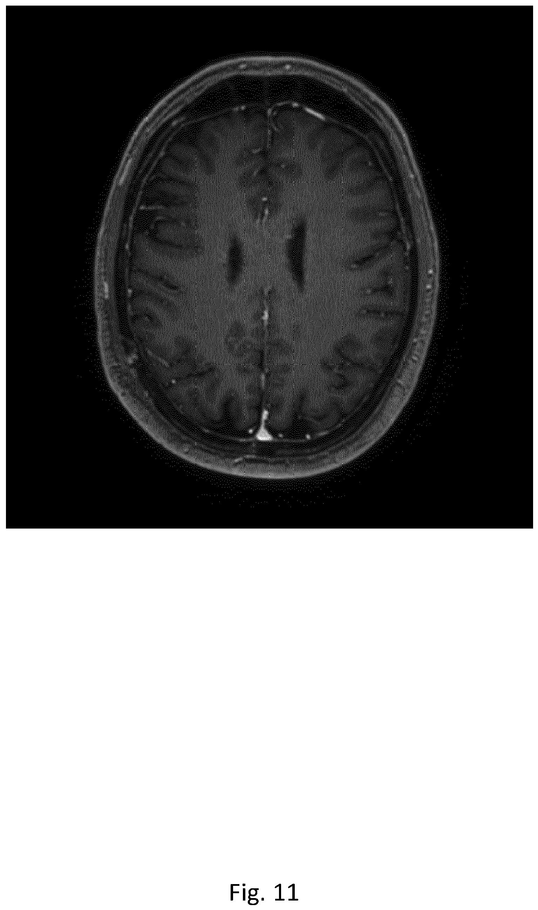

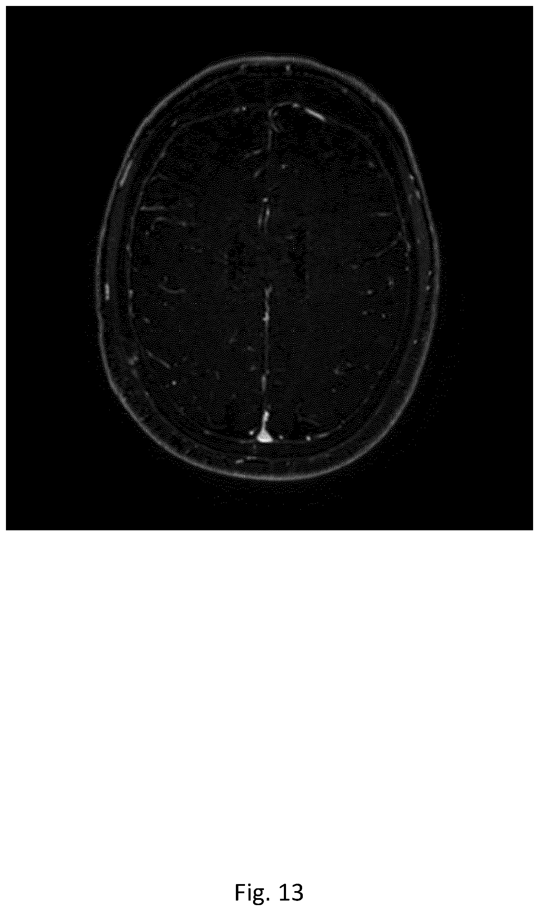

Nunmehr erfolgt aber die Berechnung zweier Subtraktionsbilder. Ein Subtraktionsbild (Fig. 13) basiert auf der Differenz der registrierten MRT-Aufnahme mit voller Kontrastmittelgabe (Fig. 11), ein sogenanntes full dose FD, während das andere Subtraktionsbild wie zuvor mittels der registrierten MRT-Aufnahme mit verminderter Kontrastmittelgabe (Fig. 12) ermittelt wird. D.h. der Prozess 200 ist für beide Subtraktionsbilder gleich.

Wie zuvor können auch die nativen T2- und/oder diffusionsgewichteten MRT-Aufnahmen im dreidimensionalen Raum registriert werden.

Wie zuvor wird die nichtlineare Transformation jeweils auf die beiden Subtraktionsbilder angewendet, um das Kontrastsignal zu verstärken.

Mittels der erhalten Subtraktionsbilder ist es nun möglich das neuronale Netzwerk zu trainieren, sodass die Differenz des errechneten kontrastverstärkten Subtraktionsbildes DFD-SD sich möglichst wenig von dem Subtraktionsbild in Bezug auf registrierte MRT-Aufnahmen mit voller Kontrastmittelgabe (Fig. 13) unterscheidet. D.h., die Ausgabe des neuronalen Netzwerkes, also das fehlerbereinigte computergenerierte Subtraktionsbild, wird hierbei in einem vordefinierten Loss-Funktional mit dem Full-Dose-Subtraktionsbild verglichen. Das Loss-Funktional kann z.B. die Summe aus drei Funktionalen sein: einem L1-Loss-Funktional, einem stärker gewichteten L1-Funktional, das nur in Bereichen des Kontrastmittels angewendet wird, und einem stärker gewichteten L1-Funktional, wobei das Gewicht durch den Laplace-Operator angewendet auf ein geglättetes Bild bestimmt werden kann.

Die Erfindung erlaubt eine drastische Reduktion der Kontrastmittelgabe bei MRT-Aufnahmen. Damit können zum einen Gefahren von Patienten als auch die Umwelt abgewendet werden, zum anderen auch Kosten für die Gabe von Kontrastmitteln reduziert werden.

Die Reduktion der Kontrastmittelgabe wird durch eine computergestützte Verstärkung des Signals erreicht, welches durch eine geringere Kontrastmitteldosis bei den MRT-Aufnahmen erzeugt wurde. Das Verfahren verwendet ein Deep-Learning-Netzwerk für die Bild-zu-Bild-Regression mit einem Vorkontrastbild und einem Niedrigkontrastbild als Eingabe und mit einem durch das neuronale Netzwerk berechneten Vollkontrastbild als Ausgabe.

Zur besseren anatomischen Abgrenzung und morphologischen Zuordnung kann durch Addition des entrauschten Subtraktionsbilds zur T1-gewichteten nativen MRT-Aufnahme eine T1-gewichtete MRT-Aufnahme generiert werden, die der FullDose-MRT-Aufnahme gleicht.

Das erfindungsgemäße Verfahren bzw. die erfindungsgemäße Vorrichtung kann durchgehend dreidimensionale Daten verwenden. Weiterhin wird bevorzugt eine Starrkörperregistrierung in drei Dimensionen verwendet. Zudem wird im Rahmen der Erfindung auf Subtraktionsbilder in der Berechnung abgestellt. Bevorzugt werden dabei nur die hervorgehobenen Regionen bearbeitet, während der Rest der Aufnahmen unverändert bleibt. Das neuronale Netzwerk verstärkt und verbessert ausschließlich diese Subtraktionsbilder, wobei bevorzugt alle verfügbaren Sequenzen (natives T1, low dose T1, T2, Diffusion) berücksichtigt werden. Das neuronale Netzwerk kann neben den T1- Sequenzen zusätzliche Informationen aus den T2- und Diffusionssequenzen gewinnen.

Ohne Beschränkung der Allgemeinheit kann die Vorrichtung 1 beispielsweise in einem programmtechnisch eingerichteten PC verkörpert sein. Ebenso kann - wie in Figur 15 angedeutet - die Vorrichtung 1 auch in ein MRT-Gerät integriert sein. Auch ist es möglich, dass die Vorrichtung 1 neben einem PC auch einen Datenspeicher DB enthält. Beispielsweise kann mittels einer geeigneten Schnittstelle I/O (z.B. eine Schnittstelle zum Internet) auch die Verarbeitung gemäß erfindungsgemäßen Verfahren als Dienstleistung angeboten werden. Mittels einer solchen Schnittstelle I/O können auch Daten von oder zu einer Datenbank zum Abruf durch die Vorrichtung 1 bzw. den PC als auch zum Abruf Bereitstellung von einer externen Quelle, z.B. einem entfernten MRT-Gerät, bereitzustellen.

D.h. die Schnittstellen I/O können ebenso wie eine direkte Anbindung (über eine bestimmte Schnittstelle und/oder ein lokales Netzwerk) als Eingabemittel an eine erfindungsgemäße Vorrichtung 1 verstanden werden.

Ohne Beschränkung der Allgemeinheit kann die Erfindung es bei der regulären Verwendung erlauben eine zugelassene Kontrastmittelgabe von z.B. 0,1 mmol/kg auf einen deutlich geringeren Anteil zu verringern. Dies trifft insbesondere für die Gadopentetat-Dimegluminhaltigen Präparate als auch für Gadobutrolhaltige Präperate zu.

Insbesondere kann ohne Beschränkung der Allgemeinheit das Kontrastmittel auf 50 % bis 1 %, insbesondere 35 % bis 5 % und insbesondere 20 % bis 5 % gegenüber einer zugelassenen Kontrastmittelgabe reduziert werden können, ohne dass hierunter die Qualität leidet, da das neuronale Netzwerk eine Kontrastverstärkung zur Verfügung stellt.

Weiterhin kann die Erfindung insbesondere auch in einem Computerprogrammprodukt zur informationstechnischen Ausgestaltung eines Computers PC zur Abarbeitung von Schritten eines erfindungsgemäßen Verfahrens verkörpert sein. Dieses Computerprogrammprodukt kann z.B. auf einem Datenträger oder als herunterladbare Signalfolge bereitgestellt sein.

Im Unterschied zum Stand der Technik kann eine Verwendung von Subtraktionsbildern als Eingang zum neuronalen Netzwerk die Artefaktanfälligkeit stark reduzieren, sodass auch nur Regionen mit einer Kontrastunterscheidung einer Verstärkung zugeführt werden. Ebenso wird durch die Verwendung von Daten im 3D-Raum sichergestellt, dass alle Daten gleichbehandelt werden. Dabei ist durch die Starrkörperregistrierung in drei Dimensionen auch sichergestellt, dass eine präzise Verarbeitung aller Daten möglich ist, sodass auch drei-dimensionale Rekonstruktionen ohne weiteres möglich sind. Darüber hinaus erlaubt die Erfindung auch die Einbindung anderer MRT-Aufnahmen und anderer Metadaten, die zu einer weiteren Verbesserung führen können.

## Patentansprüche

1. Vorrichtung (1) zur Bereitstellung von MRT-Aufnahmen in Bezug auf zumindest ein Körperteil eines Patienten mit reduzierterer Kontrastmittelgabe, aufweisend
• Eingabemittel zum Erhalt von MRT-Aufnahmen in Bezug auf zumindest ein Körperteil eines Patienten ohne Kontrastmittelgabe,
• Eingabemittel zum Erhalt von MRT-Aufnahmen in Bezug auf zumindest das Körperteil des Patienten mit Kontrastmittelgabe, wobei die für das Körperteil zugelassene Kontrastmittelgabe um mindestens 50 % reduziert ist gegenüber einer herkömmlichen MRT-Aufnahme,
• Mittel zur Bildregistrierung der MRT-Aufnahmen ohne Kontrastmittelgabe und der MRT-Aufnahmen mit Kontrastmittelgabe, wobei die Mittel zur Bildregistrierung im dreidimensionalen Raum operieren,
• Mittel zur Erstellung von zumindest einem Subtraktionsbild aus dem Vergleich von bildregistrierten MRT-Aufnahmen ohne Kontrastmittelgabe und bildregistrierten MRT-Aufnahmen mit Kontrastmittelgabe,
• Mittel zur Kontrastverstärkung basierend auf dem Subtraktionsbild, wobei die Mittel zur Kontrastverstärkung auf Basis eines trainierten neuronalen Netzwerkes zum einen mittels einer nichtlinearen Transformation eine Verstärkung als auch eine Artefaktreduktion bereitstellen.

2. Vorrichtung nach Anspruch 1, **dadurch gekennzeichnet, dass** die Mittel zur Bildregistrierung eine Starrkörperregistrierung in drei Dimensionen bereitstellen.

3. Vorrichtung nach Anspruch 1 oder 2, **dadurch gekennzeichnet, dass** die Vorrichtung weiterhin Mittel zur Interpolation aufweisen, sodass MRT-Aufnahmen unterschiedlicher Auflösung auf eine gemeinsame Auflösung vor einer weiteren Verarbeitung interpoliert werden können.

4. Vorrichtung nach Anspruch 3, **dadurch gekennzeichnet, dass** die Mittel zur Interpolation geeignet sind MRT-Aufnahmen unterschiedlicher Auflösung auf eine gemeinsame isotrope Auflösung zu führen.

5. Vorrichtung nach Anspruch 3, **dadurch gekennzeichnet, dass** die Mittel zur Interpolation eine Normierung der Intensitäten aufweisen, insbesondere eine Studentsche t-Normierung.

6. Verfahren zur Bereitstellung von MRT-Aufnahmen in Bezug auf zumindest ein Körperteil eines Patienten mit reduzierter Kontrastmittelgabe, aufweisend die Schritte
• Erhalten (100) von MRT-Aufnahmen in Bezug auf zumindest ein Körperteil eines Patienten ohne Kontrastmittelgabe (ZD),
• Erhalten (100) von MRT-Aufnahmen in Bezug auf zumindest das Körperteil des Patienten mit Kontrastmittelgabe (LD), wobei die für das Körperteil zugelassene Kontrastmittelgabe um mindestens 50 % reduziert ist gegenüber einer herkömmlichen MRT-Aufnahme,
• Durchführung einer Bildregistrierung (200) der MRT-Aufnahmen ohne Kontrastmittelgabe und der MRT-Aufnahmen mit Kontrastmittelgabe, wobei die Mittel zur Bildregistrierung im dreidimensionalen Raum operieren,
• Erstellung (300) von zumindest einem Subtraktionsbild (SD) aus dem Vergleich von bildregistrierten MRT-Aufnahmen ohne Kontrastmittelgabe und bildregistrierten MRT-Aufnahmen mit Kontrastmittelgabe,
• Bereitstellung einer Kontrastverstärkung (400) basierend auf dem Subtraktionsbild (SD), wobei auf Basis eines trainierten neuronalen Netzwerkes zum einen mittels einer nichtlinearen Transformation eine Verstärkung als auch eine Artefaktreduktion bereitgestellt wird.

7. Verfahren nach Anspruch 6, wobei der Schritt der Bildregistrierung (200) eine Starrkörperregistrierung in drei Dimensionen bereitstellt.

8. Verfahren nach einem der vorhergehenden Ansprüche 6 oder 7 **dadurch gekennzeichnet, dass** eine zugelassene Kontrastmittelgabe von 0,1 mmol/kg aufweist.

9. Verfahren nach einem der vorhergehenden Ansprüche 6 bis 8, **dadurch gekennzeichnet, dass** die reduzierte Kontrastmittelgabe 50 % bis 1 %, insbesondere 35 % bis 5 % und insbesondere 20 % bis 5 % gegenüber einer zugelassenen Kontrastmittelgabe beträgt.

10. Verfahren nach einem der vorhergehenden Ansprüche 6 bis 9, **dadurch gekennzeichnet, dass** die Bereitstellung einer Kontrastverstärkung (400) auch auf Basis von zumindest einem Metadatum (MD) bereitgestellt wird.

11. Verfahren nach Anspruch 10, **dadurch gekennzeichnet, dass** das zumindest eine Metadatum (MD) ausgewählt ist aus der Gruppe aufweisend eine Geräteidentifikation, bei der Messung verwendete Feldstärke(n), bei der Messung verwendetes Kontrastmittel, bei der Messung verwendete Kontrastmittelgabe (absolut und relativ), Gewicht des Patienten, Alter des Patienten, Größe des Patienten, Geschlecht des Patienten, Status des Patienten (z. B. prä-/ post-operativ).

12. Computerprogrammprodukt zur informationstechnischen Ausgestaltung eines Computers (PC) zur Abarbeitung von Schritten eines Verfahrens nach einem der Ansprüche 6 bis 11.

13. Verwendung einer Vorrichtung (1) nach einem der Ansprüche 1 bis 5 zur Bereitstellung von MRT-Aufnahmen in Bezug auf zumindest ein Körperteil eines Patienten mit reduzierter Kontrastmittelgabe, wobei die reduzierte Kontrastmittelgabe 50 % bis 1%, insbesondere 35 % bis 5 % und insbesondere 20 % bis 5 % gegenüber einer herkömmlichen Kontrastmittelgabe beträgt.

14. Verwendung eines Verfahrens nach einem der Ansprüche 6 bis 11 zur Bereitstellung von MRT-Aufnahmen in Bezug auf zumindest ein Körperteil eines Patienten mit reduzierter Kontrastmittelgabe, wobei die reduzierte Kontrastmittelgabe 50 % bis 1%, insbesondere 35 % bis 5 % und insbesondere 20 % bis 5 % gegenüber einer herkömmlichen Kontrastmittelgabe beträgt.
